# FASCICULE DE BREVET EUROPEEN

(11) **EP 2 350 341 B1**
(45) Date de publication et mention de la délivrance du brevet: **08.08.2012**
(21) Numéro de dépôt: 09740169.9
(22) Date de dépôt: 10.09.2009
(51) Int. Cl.: C23C 16/442, B01J 37/02, C23C 16/455

(54) **DISPOSITIF POUR LA SYNTHESE DE NANOPARTICULES PAR DEPOT CHIMIQUE EN PHASE VAPEUR EN LIT FLUIDISE**
VORRICHTUNG ZUR SYNTHESE VON NANOPARTIKELN DURCH WIRBELSCHICHT-CVD
DEVICE FOR THE SYNTHESIS OF NANOPARTICLES BY FLUIDIZED-BED CHEMICAL VAPOUR DEPOSITION

(30) Priorité: 09.10.2008 FR 0805584
(43) Date de publication de la demande: 03.08.2011
(73) Titulaire: Commissariat à l'Énergie Atomique et aux Énergies Alternatives, 75015 Paris (FR)
(72) Inventeur: FILHOL, Lionel, F-38160 Saint Sauveur (FR); THOLLON, Stéphanie, F-33770 Salles (FR); DONNET ,Sébastien, 38112 Meaudre (FR)
(74) Mandataire: Reboussin, Yohann Mickaël Noël
(86) Numéro de dépôt international: PCT/FR2009/001084
(87) Numéro de publication internationale: WO 2010/040908

(56) Documents cités:
- WO-A2-2005/004556
- WO-A2-2007/012027
- DE-A1- 2 306 402
- FR-A1- 2 354 611
- JP-A- 63 059 350
- US-A- 4 098 224

## Description

La présente invention se rapporte à un dispositif pour réaliser le dépôt chimique en phase vapeur d'espèces chimiques sur un support.

L'invention se rapporte plus précisément à un dispositif pour réaliser le dépôt chimique en phase vapeur en lit fluidisé de ces espèces chimiques.

L'invention vise en particulier le dépôt d'espèces chimiques sur des surfaces sphériques ou assimilées, telles que, à titre d'exemples non limitatifs, des poudres dont la taille des grains est nanoscopique (1 à 100nm) ou microscopique, des billes microporeuses ou des tamis moléculaires, des vermicelles ou granules.

Ce type de dépôt trouve notamment une application concrète dans la réalisation de systèmes catalytiques, par exemple pour des applications automobiles (traitement des oxydes d'azote dans les gaz d'échappement), dans le traitement de Composés Organiques Volatils (COV) qu'on rencontre dans de nombreux procédés industriels.

Il est connu que le dépôt chimique en phase vapeur (plus connu sous l'acronyme CVD pour « Chemical Vapor Deposition » en anglais) permet le dépôt d'espèces chimiques métalliques (Fe, Ru, Os, Co, Rh, Pd, Pt, etc...) sous forme de nanoparticules sur un support.

Pour cela, la CVD emploie des précurseurs organométalliques (des sels métalliques par exemple) de ces espèces chimiques, qui réagissent à la surface du substrat pour former le dépôt des espèces chimiques en question.

La technique CVD permet également le dépôt de systèmes catalytiques complets sur un support, en permettant le dépôt d'espèces chimiques telles que des oxydes (Al2O3, Ce02, YSZ, V205, BaO, Ti02, etc...) sous forme de films continus ou discontinus sur le support, suivi d'une étape de dépôt d'espèces métalliques, tel que rappelé ci-dessus.

Le dépôt de ces espèces chimiques sur des surfaces sphériques ou assimilées formant support pose cependant certaines difficultés.

Aussi, on a proposé des techniques pour améliorer le procédé CVD pour le dépôt d'espèces chimiques sur ces surfaces dites sphériques ou assimilées.

A cet effet, on a déjà proposé une technique CVD en lit fluidisé.

Ainsi le document US4098224 décrit un dispositif de dépôt en phase vapeur d'espèces chimiques sur des grains support de formes sphériques ou assimilées disposés dans un lit fluidisé et comportant: une première chambre à lit fluidisé dans laquelle est logé un élément de fluidisation, conformé en entonnoir, pour recevoir des grains support de formes sphériques ou assimilées et une deuxième chambre (définie par ses parois), en connexion fluidique avec la première chambre, destinée à la fois à fournir des précurseurs sous phase vapeur des espèces chimiques à déposer sur les grains support et à véhiculer un gaz fluidifiant en direction de la première chambre, et enfin une une flûte (probe&nozzle), disposée à l'entrée de l'élément de fluidisation (base plate), pour contrôler la répartition des précurseurs en phase vapeur et du gaz fluidifiant au sein de l'élément de fluidisation.

On peut par exemple citer le document FR 2 825 296 (D1) qui divulgue un dispositif utilisant une technique CVD en lit fluidisé. Le dispositif divulgué dans D1 comporte un sublimateur à l'intérieur duquel est disposé un précurseur organométallique sous forme solide, le sublimateur étant relié à un réservoir de gaz vecteur de sorte que le gaz vecteur est susceptible de passer à travers le précurseur organométallique afin de le sublimer (phase vapeur). Le dispositif comporte également une colonne dans laquelle sont disposés des grains supports de formes sphériques ou assimilées, ladite colonne étant disposé au-dessus du sublimateur et en connexion fluidique étanche avec celui-ci de sorte que les vapeurs du précurseur organométallique puissent se diriger vers la colonne. Le dispositif comprend également des moyens d'injection de gaz d'activation du précurseur organométallique injectés au sein du sublimateur afin d'assurer le dépôt effectif par CVD sur les grains supports.

Cette technique présente cependant un certain nombre d'inconvénients.

Il existe en effet un risque de colmatage par les grains support de l'entrée de la zone à lit fluidisé.

Il existe également un risque de coalescence des particules déposées des espèces chimiques en question. En effet, du fait que l'injection des précurseurs dans la zone à lit fluidisé n'assure pas systématiquement un brassage homogène des précurseurs dans cette zone, cela conduit à une mauvaise homogénéité du dépôt sur les grains support.

De plus, la vitesse de croissance du dépôt est difficilement contrôlable avec ces dispositifs. L'opération consistant à sublimer des précurseurs solides est une opération difficile à contrôler. En effet, dans la mesure où la surface de précurseurs solides en contact avec le flux gazeux le traversant évolue dans le temps (la forme du tas que constituent les précurseurs solides évolue, il est également possible de rencontrer des impuretés ou des traces d'humidité dans le gaz qui modifient la surface sublimable), on sublime des quantités de précurseurs mal contrôlées à chaque instant.

Par ailleurs, la surface de sublimation de ces précurseurs solides présente dans le sublimateur diminue au cours du temps, au fur et à mesure de sa consommation. En conséquence, la vitesse de dépôt des espèces chimiques diminue au cours du temps, et la durée globale du dépôt s'avère au final relativement longue, le plus souvent d'au moins 30mn.

Un objectif de l'invention est d'améliorer l'homogénéité du dépôt de ces espèces chimiques sur les grains support, dont la surface est de type sphérique ou assimilée.

Un objectif de l'invention est également de limiter voir d'éviter les risques de colmatage des grains support en entrée de la zone à lit fluidisé.

Un objectif de l'invention est encore d'accroître et de mieux contrôler la vitesse de dépôt des espèces chimiques sur des grains support.

Pour atteindre l'un au moins de ces objectifs, l'invention propose un dispositif de dépôt en phase vapeur d'espèces chimiques sur des grains support de formes sphériques ou assimilées disposés dans un lit fluidisé, comportant une première chambre à lit fluidisé destinée à recevoir des grains support de formes sphériques ou assimilées, une deuxième chambre, en connexion fluidique avec la première chambre, destinée à la fois à fournir des précurseurs sous phase vapeur des espèces chimiques à déposer sur les grains support et à véhiculer un gaz fluidifiant en direction de la première chambre, caractérisé en ce qu'il comprend un élément de fluidisation conformé en entonnoir, disposé dans la première chambre, pour recevoir les grains support, et une flûte, disposée à l'entrée de l'élément de fluidisation, pour contrôler la répartition des précurseurs en phase vapeur et du gaz fluidifiant au sein de l'élément de fluidisation.

On pourra prévoir d'autres caractéristiques techniques de l'invention, prises seules ou en combinaison :
- la flûte de répartition comprend une conduite interne pour le passage des vapeurs de précurseurs de section variable ;
- le rapport entre le diamètre (De) de la section d'entrée des vapeurs de précurseurs de la conduite de passage et le diamètre (Dₛ) de la section de sortie de cette conduite est d'au moins 2, de préférence entre 5 et 15;
- la flûte de répartition comprend une ou plusieurs rainures ou gorges externes ;
- la ou chaque rainure comporte une première partie orientée selon l'axe longitudinal de la flûte et une deuxième partie s'enroulant hélicoïdalement autour de cet axe afin de générer un vortex de gaz fluidifiant au sein de la première chambre ;
- la partie hélicoïdale de la ou de chaque rainure externe comporte une inclinaison verticale inférieur à 30°, de préférence de 20° ;
- la ou chaque rainure externe présente une largeur comprise entre 0.3 et 1.2mm et une profondeur comprise entre 0.3 et 1.2mm ;
- une extrémité de la flûte de répartition comporte un évidement dont la forme autorise le placement d'un moyen d'obturation, par exemple d'une bille ;
- il est prévu des moyens pour ajuster le positionnement de la sortie de la flûte de répartition par rapport à l'entrée de l'élément de fluidisation ;
- il est prévu des moyens de chauffage et/ou des moyens de refroidissement disposés à la base de l'élément de fluidisation, pour éviter le colmatage des grains support de l'entrée de l'élément de fluidisation ;
- il est prévu une deuxième conduite traversant la deuxième chambre et étanche par rapport à la deuxième chambre, à l'extrémité de laquelle est disposée la flûte de répartition, ia deuxième conduite étant destinée à véhiculer les précurseurs sous phase vapeur vers la flûte de répartition ;
- la deuxième conduite présente, dans sa partie basse, une pré-chambre de détente des gaz, par exemple en forme de double cône, dont la longueur n'excède pas 500mm ;
- il est prévu un injecteur pour injecter des précurseurs sous forme liquide dans la deuxième conduite ;
- il est prévu des moyens pour alimenter la deuxième conduite par un flux gazeux ;
- il est prévu des moyens pour alimenter la deuxième chambre en flux gazeux fluidifiant, lesquels comprennent un ou plusieurs réservoir(s) de gaz neutre connecté(s) à la deuxième chambre.

D'autres caractéristiques, buts et avantages de l'invention seront énoncés dans la description détaillée ci-après faite en référence aux figures qui représentent, respectivement :
- la figure 1 représente un schéma d'une vue générale du dispositif selon l'invention, représentés avec ses moyens d'alimentation en gaz et en précurseurs ;
- la figure 2 représente une vue agrandie du dispositif selon l'invention, sur les chambres du dispositif, à savoir l'évaporateur et le réacteur ;
- la figure 3 représente une vue d'un élément de fluidisation mis en oeuvre dans le réacteur du dispositif selon l'invention ;
- les figures 4a à 4c représentent plusieurs vues, respectivement une vue extérieure, une vue en coupe, et une vue de dessus d'une flûte de répartition des gaz réactifs, c'est-à-dire des précurseurs mis sous phase vapeur ;
- la figure 5 représente des résultats comparatifs d'un catalyseur en TiO2 seul, avec du Palladium, ou avec du Platine sur la capacité de stockage en hydrogène en fonction de la pression d'hydrogène, obtenu avec le dispositif selon l'invention ;
- la figure 6 représente des résultats comparatifs d'un catalyseur en MnO2 seul, avec du Palladium, ou avec du Platine sur la capacité de stockage en hydrogène en fonction de la pression d'hydrogène, obtenu avec le dispositif selon l'invention ;

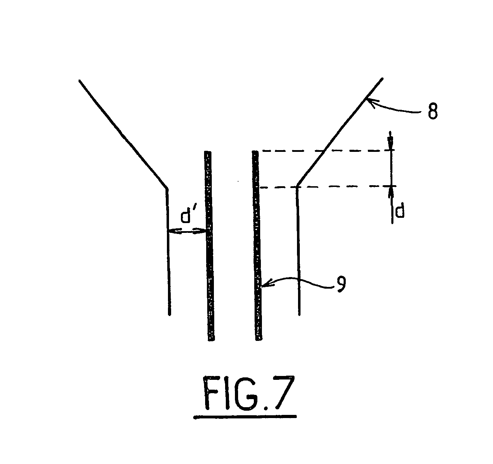

- la figure 7 représente une vue agrandie de la figure 2, au niveau de l'interface entre un élément de fluidisation du dispositif pour recevoir des grains support de formes sphériques ou assimilées et une flûte de répartition du dispositif destinée à fournir des précurseurs sous phase vapeur d'espèces chimiques à déposer sur les grains support et à véhiculer un gaz fluidifiant en direction de la première chambre, à savoir le réacteur.

La description détaillée qui suit est faite indifféremment en référence aux différentes figures.

Le dispositif comporte une première chambre 1 à lit fluidisé dans laquelle sont disposés des grains support 2 de formes sphériques ou assimilés, et une deuxième chambre 3, en connexion fluidique avec la première chambre 1.

La première chambre 1 constitue un réacteur dans lequel l'opération de dépôt proprement dite a lieu. L'enceinte extérieure de cette première chambre 1 est constituée d'un tube en quartz ou d'un tube métallique. Son diamètre est par exemple de 100mm, et sa hauteur comprise entre 600mm et 1000mm. Ces dimensions n'ont rien de spécifique, et sont simplement choisies en fonction de la quantité de grains support et de matériel à y insérer.

La deuxième chambre 3 est destinée à fournir, sous phase vapeur (gaz réactifs), des précurseurs des espèces chimiques qu'on cherche à déposer sur les grains support.

A cet effet, elle prévoit une conduite 4, parfaitement étanche par rapport à la deuxième chambre 3, au bas de laquelle sont introduits des précurseurs des espèces chimiques à déposer sur les grains support, ainsi que des gaz vecteurs qui formeront les gaz réactifs après évaporation du liquide précurseur. Plus précisément, la conduite 4 comporte une pré-chambre de détente 41 dans laquelle des précurseurs sous forme liquide sont injectés (injecteur 13) avec des gaz vecteurs (ouvertures 14). La conduite 4 peut par exemple être un tube dont le diamètre est faible, à savoir compris entre 8mm et 12mm, par exemple de 10mm, rectiligne et court, à savoir d'une longueur inférieure à 500mm, par exemple de 450mm. Cette pré-chambre 41 présente par exemple la forme d'un double cône disposé en partie basse de la conduite 4, et donc en partie basse de la deuxième chambre 3.

Le fait d'introduire les précurseurs dans une telle conduite, c'est-à-dire comprenant une pré-chambre 41 associée à une longueur courte, est original ; les solutions usuellement employées considèrent un chemin d'évaporation indirect et une longueur d'évaporation d'au moins 650mm comme indispensable.

Le dispositif prévoit également un moyen de chauffage 5, s'étendant par exemple le long d'une paroi externe de la deuxième chambre 3, pour assurer la mise en phase vapeur des précurseurs. Ce moyen de chauffage peut par exemple fournir des températures comprises entre 120°C et 280°C, température dont la régulation peut être assurée par la mise en place de thermocouples.

Les précurseurs, par exemple des précurseurs organométalliques, sont injectés sous forme liquide. L'injection liquide permet de contrôler la quantité de précurseurs injectés dans le dispositif, et par suite la vitesse de croissance du dépôt des espèces chimiques sur les grains support, et l'épaisseur des couches de dépôt.

La deuxième chambre 3 est également destinée à véhiculer un gaz fluidifiant en direction de la première chambre 1. Elle prévoit ainsi une ou plusieurs entrées 31 pour un ou des gaz fluidifiants.

Par suite, le dispositif prévoit également des moyens pour alimenter la deuxième chambre 3 en flux gazeux fluidifiant, lesquels moyens comprennent un ou plusieurs réservoir(s) de gaz 7 connecté(s) à la deuxième chambre 3. Par gaz, on entend ici des gaz neutres (Argon, Azote, Hélium) ou un mélange de gaz neutres et réactifs pouvant aller jusqu'à 80% de gaz réactifs (Oxygène, Hydrogène). Ces moyens 7 permettent également d'alimenter en gaz vecteurs la conduite 4 dans laquelle les précurseurs s'évaporent.

Le dispositif comprend également un élément de fluidisation 8 disposé dans la première chambre 1 pour recevoir les grains support 2.

Cet élément de fluidisation 8 prend avantageusement la forme d'un cône ou plus généralement d'une forme adaptée à la réalisation d'une fonction d'entonnoir visant à rassembler les grains support à traiter en regard ou dans la proximité de la partie débouchante d'une flûte de répartition 9 que nous détaillons par la suite.

Dans un souci de simplification, la suite de la description se base sur la réalisation avantageuse dite de cône de fluidisation 8 pour l'élément en question, mais ceci ne limite en rien la portée de l'invention qui s'étend à tout élément susceptible de jouer la même fonction ; c'est-à-dire à tout élément de fluidisation conformé en entonnoir.

Ce cône de fluidisation 8 a, dans sa partie basse, une forme de cône ou d'entonnoir facilitant l'entée des gaz fluidifiants. Ces gaz fluidifiants passent en effet depuis la deuxième chambre 3 vers le cône de fluidisation 8 par l'intermédiaire d'un espace périphérique prévu entre le cône 8 en question et une flûte de répartition 9 qui sera détaillée dans la suite de la description.

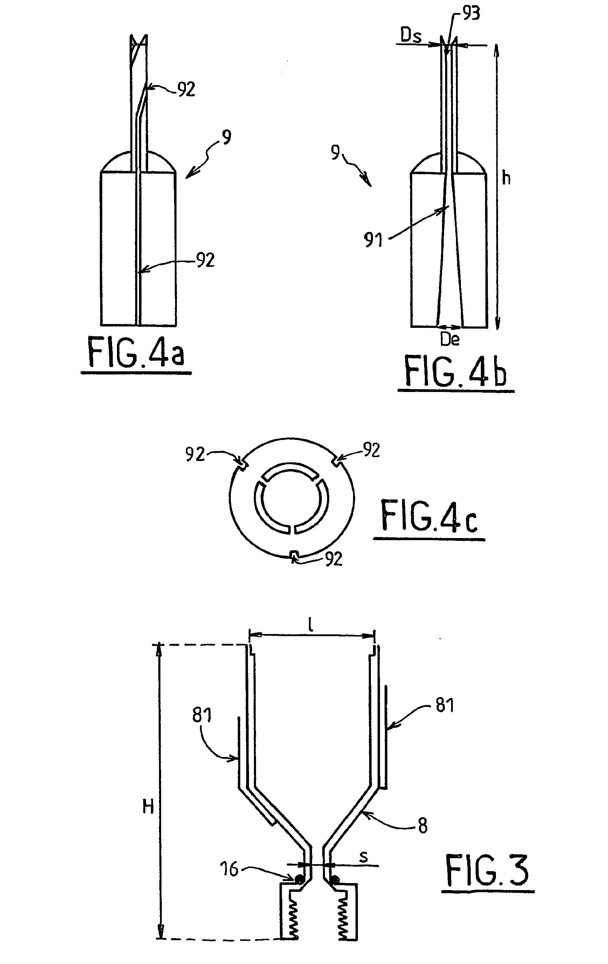

Le cône de fluidisation 8 pourra être réalisé en un matériau conducteur, par exemple en inconel, inox ou cuivre. Selon l'exemple non limitatif illustré sur la figure 3, sa hauteur totale H vaut H = 175mm, sa largeur I = 65mm, et la section de passage s (diamètre) dans laquelle doit s'insérer la flûte de répartition 9 est de l'ordre de s = 5mm.

Le cône de fluidisation 8 comporte des gorges 81 sur son pourtour extérieur, qui permettent de loger des thermocouples.

Le dispositif comporte des moyens de chauffage 10, utilisant l'information fournie par les thermocouples disposés dans les gorges 81, permettant de régler la température dans la première chambre 1. Les moyens de chauffage 10 peuvent être formés par un four résistif monté sur glissières, ainsi capable d'envelopper la première chambre 1 ou de s'en dégager, le four permettant ainsi d'ajuster le gradient thermique entre la première chambre 2 et la deuxième chambre 3. On peut également envisager l'emploi d'un four inductif. Ces moyens de chauffage 10 peuvent produire une température par exemple réglable entre 320 et 700°C.

Le cône de fluidisation 8 peut également comporter, au niveau de son extrémité supérieure, un clapet 82 dont la fonction est de limiter voire d'empêcher des grains support de taille faibles, typiquement des poudres dont les grains sont inférieurs au µm, de s'envoler du volume défini par le cône de fluidisation 8.

Le dispositif comprend une flûte 9, disposée à l'entrée du cône de fluidisation 8, pour contrôler notamment la répartition des précurseurs en phase vapeur au sein du cône de fluidisation 8.

La flûte de répartition 9 comprend une conduite interne 91 pour le passage des vapeurs de précurseurs dont la section est variable. Plus précisément, le rapport entre le diamètre de la section d'entrée De des vapeurs de précurseurs de la conduite de passage 91 et le diamètre de la section de sortie Dₛ de cette conduite 91 est d'au moins 2, de préférence entre 5 et 15. Par exemple, on peut prévoir une section d'entrée dont le diamètre est d'environ De = 10mm, le diamètre de la section de sortie étant quant à lui de Dₛ = 1 mm. Le fait de rétrécir la section de passage (forme conique de la conduite 91) du flux gazeux permet d'accélérer la vitesse des gaz contenant les précurseurs, ce qui évite ainsi toute condensation et/ou dépôt dans la flûte de répartition 8.

Avantageusement, la variation de la section de la conduite interne 91 est continue le long de la flûte 9 de manière à former un cône. Eventuellement, la conduite interne 91 peut présenter une partie conique, suivie d'une partie de section constante égale à la plus petite section du cône, tel qu'illustré sur la figure 4b.

La flûte de répartition 9 est également agencée, par rapport au cône de fluidisation 8, de sorte que les gaz fluidifiants passent entre la partie externe du la flûte 9 et du cône de fluidisation 8.

Compte tenu de cet écoulement, la flûte de répartition 9 comprend une ou plusieurs rainures externes 92. Ces rainures externes 92 peuvent être orientées selon l'axe longitudinal de la flûte 9 ou présenter une première partie orientée selon l'axe longitudinal de la flûte et une deuxième partie s'enroulant hélicoïdalement autour de cet axe.

Dans ce deuxième cas, l'enroulement hélicoïdal permet de générer un vortex de gaz fluidifiant au sein de la première chambre 1. L'inclinaison verticale de la ou chaque rainure externe 92 est inférieur à 30°, et plus généralement compris entre 0° et 20°. Il est choisi en fonction de la nature des grains support 2 qui sont à fluidifier pour assurer un brassage efficace et homogène des grains support 2 au sein du lit fluidisé. On comprend par exemple que plus les grains support sont gros, plus il sera préférable de générer un vortex important.

La flûte de répartition 9 pourra comprendre jusqu'à 12 rainures externes, de largeur comprise entre 0.3 et 1.2mm et de profondeur comprise entre 0.3 et 1.2mm. En particulier, le nombre de rainures externes 92 est déterminé en fonction de la taille des grains support à traiter. Plus les grains support sont gros et plus il est préférable de mettre en oeuvre une flûte de répartition comportant peu de rainures externes (inversement proportionnel), présentant des dimensions importantes (profondeur et largeur étant de l'ordre du mm). A contrario, plus les grains support sont de taille faible, plus il est préférable de mettre en oeuvre une flûte de répartition 9 comportant de nombreuses rainures externes, présentant des dimensions faibles (profondeur et largeur étant alors de l'ordre de 0.3mm). Bien entendu, les dimensions sont modifiables en fonction des besoins de l'homme du métier.

La flûte de répartition 9 comporte également un évidement 93 dont la forme autorise le placement d'un moyen d'obturation, par exemple d'une bille d'un diamètre compris entre 3mm et 7mm, apte à boucher l'orifice de sortie (diamètre Dₛ) de la conduite de passage 91. Ainsi, lorsque aucun flux gazeux ne passe dans la conduite 91, l'orifice de sortie de cette conduite 91 est obturé ce qui empêche les grains support 2 de passer dans la flûte de répartition 9.

Avantageusement, la flûte 9 s'insère dans la base du cône de fluidisation 8 de façon à laisser un espacement d' compris entre 0.2mm et 0.6mm, pour le passage des gaz fluidifiants.

La flûte de répartition 9 pourra par exemple être réalisée en un matériau tel que l'inconel.

Au niveau de l'interface entre les deux chambres 1 et 3, il est prévu une bride 15. Cette bride 15 est équipée d'un bouclier thermique, préférentiellement constitué de 5 anneaux en inox, d'épaisseur faible, par exemple 1mm, chacun d'entre eux étant espacé d'une rondelle elle-même en inox. Ce bouclier permet d'une part de renvoyer le rayonnement thermique lié au niveau de température régnant dans les chambres 1, 3 vers le cône de fluidisation 8 ; et d'autre part de protéger la base de la flûte de répartition 9 contre un trop fort gradient thermique susceptible de régner au niveau de cette interface entre les deux chambres 1, 3.

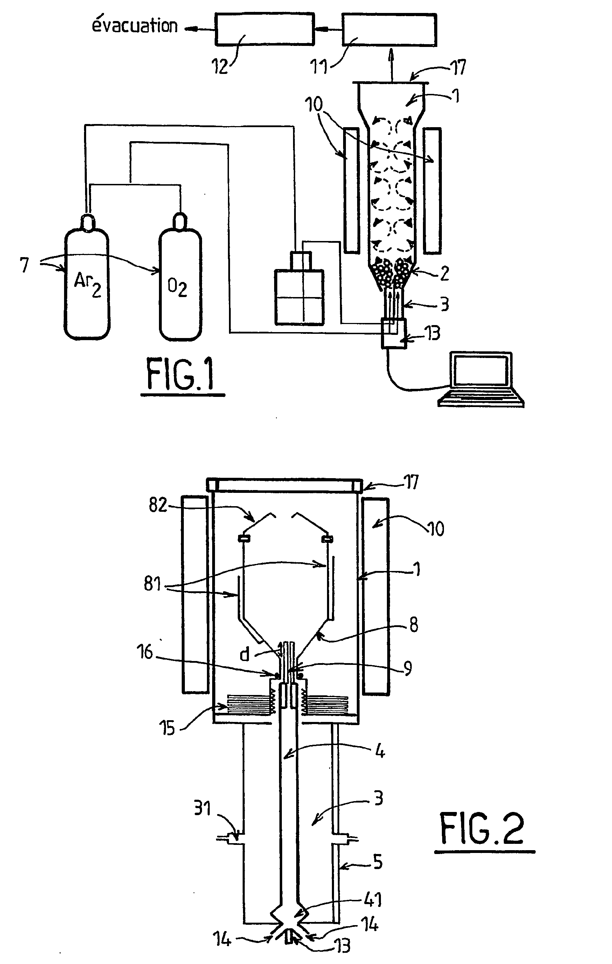

Le positionnement précis de la flûte de répartition 9 par rapport au cône de fluidisation 8 peut être ajusté. A cet effet, le dispositif prévoit des moyens (non représentés) pour ajuster le positionnement de la sortie de la flûte de répartition 9 par rapport à l'entrée du cône de fluidisation 8 (il s'agit de la distance d sur la figure 2). Ces moyens permettent ainsi de régler la section de passage laissé au gaz fluidifiant les grains support, section située entre le cône 8 et la flûte de répartition 9.

La flûte de répartition 9, par son positionnement, permet ainsi de contrôler la répartition des gaz fluidifiants au sein du cône de fluidisation 8.

On comprend que plus les grains support 2 sont de taille importante, plus il est préférable de laisser un passage conséquent entre le cône de fluidisation 8 et la flûte de répartition pour les fluidifier.

Ces moyens d'ajustement offrent donc une alternative ou un moyen de réglage complémentaire au choix d'une flûte 9 comportant des rainures externes dont le nombre et/ou le pas hélicoïdal est judicieusement choisi.

Le dispositif peut également comprendre, au niveau de la base du cône de fluidisation 8, des moyens de chauffage 16, par exemple des cartouches chauffantes, et/ou des moyens de refroidissement 16 pour contrôler le gradient thermique au niveau de la zone de dépôt. Ceci permet de limiter voire d'éviter le colmatage de l'entrée du cône de fluidisation par les grains support.

Bien que l'enceinte formée par la première chambre 1 soit fermée (hublot en quartz 17 par exemple sur la partie supérieure de la première chambre 1), le dispositif comprend un filtre à particules dit « très haute efficacité » permettant de piéger les poudres potentiellement présentes en sortie de la première chambre 1. Le filtre 11 est suivi d'une pompe 12 qui assure la mise en mouvement des différents flux gazeux au sein du dispositif. Le fait de disposer le filtre 11 en amont (compte tenu du sens de circulation du flux gazeux) de la pompe 12 permet de le protéger. La pompe 12 peut effectuer un pompage « sec », mais une pompe à palettes peut également convenir, à l'exception des cas où on a du méthane ou de l'hydrogène (H₂).

Nous allons maintenant détailler quelques exemples des dépôts envisageables avec le dispositif selon l'invention.

La réalisation d'un catalyseur performant passe par deux étapes :
- étape 1 : étape de dépôt d'un « washcoat » (précouche catalytique composée d'un ou plusieurs oxydes) ;
- étape 2 : étape de dispersion de métaux, le plus souvent nobles, sous forme de nanoparticules (diamètre généralement inférieur à 20nm) sur le « washcoat » préalablement déposé.

### Exemple 1

Un premier exemple de mise en oeuvre de l'invention consiste à réaliser un dépôt (étape 2) de particules de Platine (métal noble) sur des billes d'alumine formant grains support, pour des applications de traitement des Composés Organiques Volatils (COV).

Ces billes dont le diamètre est de l'ordre de 2 mm, et dont le poids total est compris entre 1.5g et 12g sont directement placés dans le cône de fluidisation 8 de la première chambre 1, mis en agitation (lit fluidisé) par un flux d'argon, et chauffées par le four 10.

La pression de travail dans le réacteur est compris entre 5 et 40 Torrs, le débit total de gaz est de 80 à 250sccm (standard centimètre cube par minute) avec une teneur en Argon comprise entre 20% et 40%, le précurseur liquide utilisé est du Pt(acétylacétone) dilué dans du toluène à une concentration de 0.03 mol/l. Le précurseur est injecté à une fréquence de 2Hz pour un temps d'ouverture de 3ms.

Pour des temps de dépôt inférieurs à 30s, on obtient des dépôts de nanoparticules dispersées ; et au-delà des couches discontinues ou continues si le temps de dépôt augmente encore.

La taille des particules est comprise entre 50 et 200nm en fonction des conditions opératoires telles que la température régnant dans le réacteur (première chambre 1), le temps de dépôt, etc...

### Exemple 2

Ce deuxième exemple de mise en oeuvre de l'invention concerne le domaine de la réalisation de matériaux de stockage pour l'hydrogène. Il consiste au dépôt (étape2) de métaux sous forme de nanoparticules sur des poudres macroporeuses de TiO2 ou de Mn02. La taille des grains support formant la poudre de Ti02 est inférieure à 25nm, et celle des grains support formant la poudre de MnO2 est inférieure à 10µm.

Ces poudres, d'un poids total compris entre 0.5 et 5g, sont placées directement dans le cône de fluidisation 8, mis en agitation (lit fluidisé) par un flux d'argon, et chauffées par le four 10.

La pression de travail dans le réacteur est comprise entre 40 Torrs et 750 Torrs, le débit totale de gaz est de 100 à 200 sccm avec une teneur en Argon comprise entre 40% et 80%, les précurseurs utilisés étant le Pt(acétylacétone) ou le Pd(acétylacétone) dilués dans du toluène à une concentration de 0.03mol/l. Le débit de précurseurs est injecté à une fréquence de 2Hz avec un temps d'ouverture de 3ms, de sorte à fournir un débit de précurseur de 1,9 ml/mn.

La température de l'évaporateur (conduite étanche 4, disposée dans la deuxième chambre 3) a été fixée à 160°C, la température de dépôt (four 10) étant quant à elle réglée à 320°C.

Avec ces conditions opératoires, le taux de chargement en métal Pt (Platine) sur les grains support en TiO2 est de 5% en poids, le taux de chargement en Pt sur les grains support en Mn02 est de 6,4% en poids, le taux de chargement en Pd (Palladium) sur les grains support en TiO2 est de 3,9% en poids, et le taux de chargement en Pd sur les grains support en Mn02 est de 5% en poids.

Des mesures de surface spécifiques réalisées dans de l'azote liquide indiquent que les échantillons ainsi traités sont mésoporeux (alors que les poudres initiales sont macroporeuses) avec un diamètre de pore moyen de 8,5nm pour une surface spécifique de 135,46 m²/g pour les grains support en Ti02 et de 26,14 m²/g pour les grains support en MnO2.

Des mesures de capacité de stockage de l'hydrogène sont réalisées dans l'azote liquide et sont obtenues par différence de volume dans un équipement de type Sievert. Ainsi, la capacité de stockage de l'hydrogène entre Ti02 seul et Ti02 dopé au Pt est multipliée par trois sous 10 bars de pression d'hydrogène. Des performances encore meilleures sont obtenues avec la poudre de Mn02 dopée au Pt sous 10 bars de pression d'hydrogène.

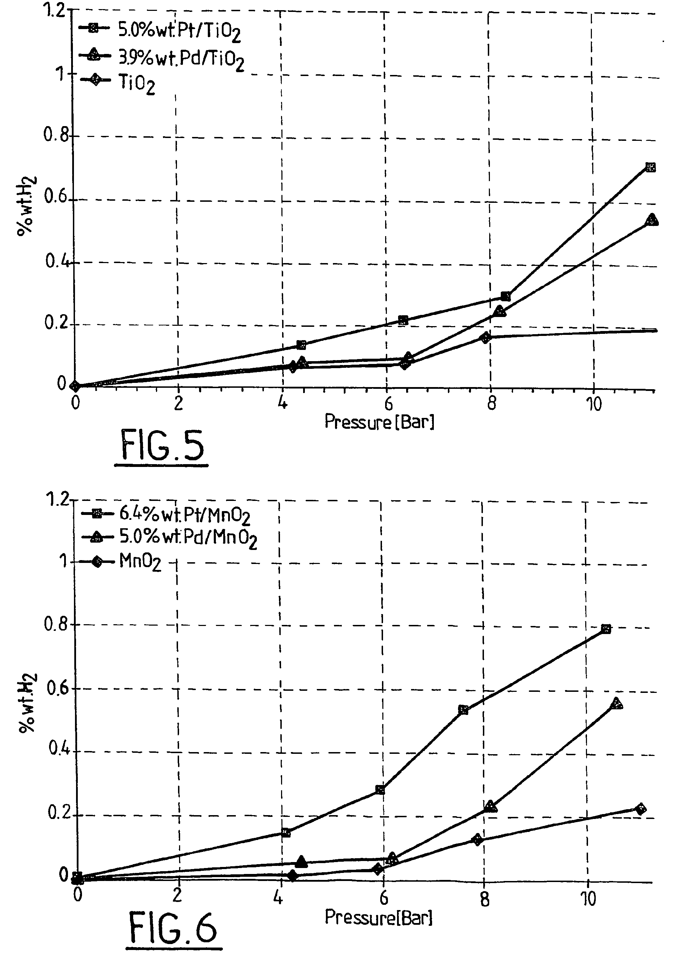

Les résultats comparatifs obtenus pour Ti02 seul, Pt/TiO2 et Pd/TiO2 sont illustrés sur la figure 5. Ils représentent l'évolution en poids de l'hydrogène capté par les grains supports (capacité de stockage de l'hydrogène) en fonction de la pression d'hydrogène.

Les résultats comparatifs obtenus pour Mn02 seul, Pt/MnO2 et Pd/Mn02 sont illustrés sur la figure 6. Ils représentent également l'évolution en poids de l'hydrogène capté par les grains supports (capacité de stockage de l'hydrogène) en fonction de la pression d'hydrogène.

En définitive, grâce aux différents moyens d'ajustement du dispositif, spécifiquement conçus pour des structures de types poudres ou grains, le dispositif est apte à déposer des espèces chimiques sur une large gamme de taille des grains support 2, par exemple pour des grains support dont le diamètre va de 50nm à quelques millimètres.

Ce dépôt peut par ailleurs être effectué de manière homogène sur les grains support, par la maîtrise du lit fluidisé (couple cône de fluidisation/flûte et notamment leur positionnement respectif ; forme et nombre des rainures externes de la flûte) qui assure un bon brassage des grains support. Par homogène, on entend ici que l'ensemble des grains supports subit un dépôt, et que l'épaisseur et/ou la répartition du dépôt est comparable d'un grain support à l'autre.

De plus, par l'emploi d'une injection de précurseurs sous forme liquide, le dispositif permet de contrôler la quantité de précurseurs fournis sous forme vapeur tout au long de l'opération de dépôt. Il est donc possible, et ce contrairement aux dispositifs employant des précurseurs sous forme solide, de contrôler la vitesse de croissance de la couche de dépôt sur les grains support, et par suite l'épaisseur de cette couche de dépôt en fonction de la durée de mise en oeuvre du procédé.

Ce facteur temps de mise en oeuvre du procédé combiné à l'utilisation d'une injection liquide des précurseurs permet même le dépôt de couches continues ou discontinues sur les grains support, et en définitive que ceux-ci soient denses ou poreux compte tenu de la maîtrise du lit fluidisé offerte par le dispositif.

Plus généralement, la maîtrise des conditions opératoires offertes par le présent dispositif permet de moduler la morphologie (taille) et la concentration (dispersion) et d'accéder ainsi à la synthèse de particules de taille nanométrique (par exemple inférieure à 10nm) très finement dispersées (distance inter-particulaire inférieure à 50nm).

On a constaté que le temps de dépôt était également nettement réduit par rapport aux dispositifs existants. En effet, les temps de dépôt typiques avec le dispositif de l'invention sont de quelques dizaines de secondes, alors qu'ils sont de l'ordre de quelques dizaines de minutes voire plus avec des dispositifs connus.

Enfin, le dispositif selon l'invention ne permet pas uniquement le dépôt d'espèces chimiques métalliques (ce que nous appelons l'étape 2) sur un « washcoat », mais permet également le dépôt de systèmes catalytiques complets (« washcoat » + métal) dans ce même dispositif. Il est donc envisageable avec le dispositif selon l'invention d'effectuer un dépôt de composés chimiques de type oxydes en couches minces (Al2O3, CeO2, YSZ, V205, BaO, TiO2,...), puis des espèces chimiques métalliques (Fe, Ru, Os, Co, Rh, Ir, Ni, Pd, Pt, Cu, Ag, Au, ...) sous forme de nanoparticules.

## Revendications

1. Dispositif de dépôt en phase vapeur d'espèces chimiques sur des grains support de formes sphériques ou assimilées disposés dans un lit fluidisé, comportant :
• une première chambre (1) à lit fluidisé dans laquelle est logé un élément de fluidisation (8), conformé en entonnoir, pour recevoir des grains support (2) de formes sphériques ou assimilées,
• une deuxième chambre (3), en connexion fluidique avec la première chambre (1), destinée à la fois à fournir des précurseurs sous phase vapeur des espèces chimiques à déposer sur les grains support (2) et à véhiculer un gaz fluidifiant en direction de la première chambre (1),
• une flûte (9), disposée à l'entrée de l'élément de fluidisation (8), pour contrôler la répartition des précurseurs en phase vapeur et du gaz fluidifiant au sein de l'élément de fluidisation (8),
**caractérisé en ce que** la flûte de répartition (9) comprend une ou plusieurs rainures ou gorges externes (92), la ou chaque rainure (92) comportant une première partie orientée selon l'axe longitudinal de la flûte (9) et une deuxième partie s'enroulant hélicoïdalement autour de cet axe afin de générer un vortex de gaz fluidifiant au sein de la première chambre (1).

2. Dispositif selon la revendication 1, dans lequel la flûte de répartition (9) comprend une conduite interne (91) pour le passage des vapeurs de précurseurs de section variable.

3. Dispositif selon la revendication précédente, dans lequel le rapport entre le diamètre (De) de la section d'entrée des vapeurs de précurseurs de la conduite de passage et le diamètre (Dₛ) de la section de sortie de cette conduite est d'au moins 2, de préférence entre 5 et 15.

4. Dispositif selon l'une des revendications précédentes, dans lequel la partie hélicoïdale de la ou de chaque rainure externe (92) comporte une inclinaison verticale inférieure à 30°, de préférence de 20°.

5. Dispositif selon l'une des revendications précédentes, dans lequel la ou chaque rainure externe (92) présente une largeur comprise entre 0.3 et 1.2mm et une profondeur comprise entre 0.3 et 1.2mm.

6. Dispositif selon l'une des revendications précédentes, dans lequel une extrémité de la flûte de répartition (9) comporte un évidement (93) dont la forme autorise le placement d'un moyen d'obturation, par exemple d'une bille.

7. Dispositif selon l'une des revendications précédentes, dans lequel il est prévu des moyens pour ajuster le positionnement de la sortie de la flûte de répartition par rapport à l'entrée de l'élément de fluidisation (8).

8. Dispositif selon l'une des revendications précédentes, dans lequel il est prévu des moyens de chauffage (16) et/ou des moyens de refroidissement (16) disposés à la base de l'élément de fluidisation (8), pour éviter le colmatage de l'entrée de l'élément de fluidisation par les grains support.

9. Dispositif selon l'une des revendications précédentes, dans lequel il est prévu une deuxième conduite (4) traversant la deuxième chambre (3) et étanche par rapport à la deuxième chambre (3), à l'extrémité de laquelle est disposée la flûte de répartition (9), la deuxième conduite (4) étant destinée à véhiculer les précurseurs sous phase vapeur vers la flûte de répartition (9).

10. Dispositif selon la revendication précédente, dans lequel la deuxième conduite (4) présente, dans sa partie basse, une pré-chambre (41) de détente des gaz, par exemple en forme de double cône, dont la longueur n'excède pas 500mm.

11. Dispositif selon l'une des revendications 9 ou 10, dans lequel il est prévu un injecteur (13) pour injecter des précurseurs sous forme liquide dans la deuxième conduite (4).

12. Dispositif selon l'une des revendications 9 à 11, dans lequel il est prévu des moyens pour alimenter la deuxième conduite (4) par un flux gazeux.

13. Dispositif selon l'une des revendications précédentes, dans lequel il est prévu des moyens pour alimenter la deuxième chambre (3) en flux gazeux fluidifiant, lesquels comprennent un ou plusieurs réservoir(s) de gaz neutre connecté(s) à la deuxième chambre.

## Claims

1. A device for vapor deposition of chemical species on support grains of spherical or similar shape disposed in a fluidized bed, the device comprising:
• a first chamber (1) having a fluidized bed in which a funnel-shaped fluidizer element (8) is housed in order to receive support grains (2) of spherical or similar shape;
• a second chamber (3) in fluid flow connection with the first chamber (1) serving both to deliver precursors in the vapor phase of chemical species to be deposited on the support grains (2) and to convey a fluidizing gas towards the first chamber (1); and
• a flute (9) placed at the inlet of the fluidizer element (8) to control the distribution of the vapor phase precursors and of the fluidizing gas within the fluidizer element (8);
the device being **characterized in that** the distributor flute (9) includes one or more outer grooves (92), the or each groove (92) having a first portion oriented along the longitudinal axis of the flute (9) and a second portion winding helically around said axis in order to generate a fluidizing gas vortex within the first chamber (1).

2. A device according to claim 1, wherein the distributor flute (9) comprises an inner pipe (91) for passing precursor vapors, the inner pipe being of varying section.

3. A device according to the preceding claim, wherein the ratio between the diameter (Dₑ) of the precursor vapor inlet section into the inner pipe and the diameter (Dₛ) of the outlet section from said pipe is at least 2, and preferably lies in the range 5 to 15.

4. A device according to any preceding claim, wherein the helical portion of the or each outer groove (92) has a vertical inclination of less than 30°, preferably of less than 20°.

5. A device according to any preceding claim, wherein the or each outer groove (92) presents a width lying in the range 0.3 mm to 1.2 mm, and a depth lying in the range 0.3 mm to 1.2 mm.

6. A device according to any preceding claim, wherein one end of the distributor flute (9) includes a recess (93) of a shape that allows shutter means to be placed therein, e.g. a ball.

7. A device according to any preceding claim, wherein means are provided for adjusting the position of the distributor flute outlet relative to the inlet of the fluidizer element (8).

8. A device according to any preceding claim, wherein heater means (16) and/or cooling means (16) are provided that are located at the base of the fluidizer element (8), in order to avoid the inlet of the fluidizer element being clogged by the support grains.

9. A device according to any preceding claim, wherein a second pipe (4) is provided that passes through the second chamber (3) and that is leaktight relative to the second chamber (3), with the distributor flute (9) being located at the end thereof, the second pipe (4) serving to convey the precursors in the vapor phase towards the distributor flute (9).

10. A device according to the preceding claim, wherein the second pipe (4) presents, in its bottom portion, a gas-expansion pre-chamber (41), e.g. in the form of a double cone, and presenting a length that does not exceed 500 mm.

11. A device according to claim 9 or claim 10, wherein an injector (13) is provided to inject precursors in liquid form into the second pipe (4).

12. A device according to any one of claims 9 to 11, wherein means are provided for feeding the second pipe (4) with a gas stream.

13. A device according to any preceding claim, wherein means are provided for feeding the second chamber (3) with a fluidizing gas stream, which means comprise one or more inert gas reservoirs connected to the second chamber.

## Patentansprüche

1. Vorrichtung für die Abscheidung aus der Gasphase von chemischen Spezies auf Trägerkörnern mit sphärischer oder dazu ähnlicher Form, die in einer Wirbelschicht angeordnet sind, wobei die Vorrichtung folgendes aufweist:
• eine erste Kammer (1) mit einer Wirbelschicht, in der sich ein trichterförmiges Fluidisierungselement (8) zum Aufnehmen der Trägerkörner (2) mit sphärischer oder dazu ähnlicher Form befindet,
• eine mit der ersten Kammer (1) in Fluidverbindung stehende zweite Kammer (3), die dazu bestimmt ist, in der Gasphase befindliche Vorläufer der auf den Trägerkörnern (2) abzuscheidenden chemischen Spezies zur Verfügung zu stellen sowie ein Fluidisierungsgas auf die erste Kammer (1) hin zu übertragen,
• eine am Einlass des Fluidisierungselementes (8) angeordnete Röhre (9) zum Steuern der Verteilung der in der Gasphase befindlichen Vorläufer und des Fluidisierungsgases im Inneren des Fluidisierungselementes (8),
**dadurch gekennzeichnet, dass** die Verteilerröhre (9) eine oder mehrere äußere Rillen oder Kehlungen (92) aufweist, wobei die bzw. jede Rille (92) einen ersten Teil aufweist, der entlang der Längsachse der Röhre (9) orientiert ist, und einen zweiten Teil, der wendelförmig um diese Achse gewunden ist, um im Inneren der ersten Kammer (1) einen Wirbel von Fluidisierungsgas zu erzeugen.

2. Vorrichtung nach Anspruch 1, wobei die Verteilerröhre (9) eine innere Rohrleitung (91) mit einem veränderlichen Querschnitt zum Durchführen der Vorläufergase aufweist.

3. Vorrichtung nach dem vorhergehenden Anspruch, wobei das Verhältnis zwischen dem Durchmesser (Dₑ) des Abschnitts der Durchführungsrohrleitung für den Eintritt der Vorläufergase und dem Durchmesser (Dₛ) des Austrittsabschnitts dieser Rohrleitung mindestens 2, bevorzugt zwischen 5 und 15 beträgt.

4. Vorrichtung nach einem der vorhergehenden Ansprüche, wobei der wendelförmige Teil der bzw. jeder äußeren Rille (92) eine vertikale Neigung von weniger als 30°, bevorzugt weniger als 20° aufweist.

5. Vorrichtung nach einem der vorhergehenden Ansprüche, wobei die bzw. jede äußere Rille (92) eine Breite von zwischen 0,3 und 1,2 mm und eine Tiefe von zwischen 0,3 und 1,2 mm aufweist.

6. Vorrichtung nach einem der vorhergehenden Ansprüche, wobei ein Ende der Verteilerröhre (9) eine Aussparung (93) aufweist, deren Form das Anordnen einer Verschlusseinrichtung, z.B. einer Kugel, ermöglicht.

7. Vorrichtung nach einem der vorhergehenden Ansprüche, wobei Einrichtungen zum Einstellen der Positionierung des Austritts aus der Verteilerröhre in Bezug auf den Eintritt des Fluidisierungselementes (8) vorgesehen sind.

8. Vorrichtung nach einem der vorhergehenden Ansprüche, wobei an der Basis des Fluidisierungselementes (8) angeordnete Heizeinrichtungen (16) und/oder Kühleinrichtungen (16) vorgesehen sind, um ein Zusetzen des Eintritts des Fluidisierungselementes durch die Trägerkörner zu verhindern.

9. Vorrichtung nach einem der vorhergehenden Ansprüche, wobei eine zweite Rohrleitung (4) vorgesehen ist, die sich durch die zweite Kammer (3) erstreckt und gegenüber der zweiten Kammer (3) dicht ist, und an deren Ende die Verteilerröhre (9) angeordnet ist, wobei die zweite Rohrleitung (4) dazu vorgesehen ist, die in der Gasphase vorliegenden Vorläufer auf die Verteilerröhre (9) hin zu übertragen.

10. Vorrichtung nach dem vorhergehenden Anspruch, wobei die zweite Rohrleitung (4) in ihrem unteren Teil eine Vorkammer (41) zum Entspannen der Gase aufweist, beispielsweise mit der Form eines Doppelkegels, deren Länge 500 mm nicht übersteigt.

11. Vorrichtung nach einem der Ansprüche 9 oder 10, wobei eine Einspritzeinrichtung (13) zum Einspritzen der Vorläufer in flüssiger Form in die zweite Rohrleitung (4) vorgesehen ist.

12. Vorrichtung nach einem der Ansprüche 9 bis 11, wobei Einrichtungen zum Zuführen eines Gasflusses zu der zweiten Rohrleitung (4) vorgesehen sind.

13. Vorrichtung nach einem der vorhergehenden Ansprüche, wobei Einrichtungen zum Zuführen eines Fluidisierungsgasflusses zu der zweiten Kammer (3) vorgesehen sind, welche einen oder mehrere Vorratsbehälter für Neutralgas(e) aufweisen, der/die mit der zweiten Kammer verbunden ist/sind.
